Europäisches Patentamt

European Patent Office

Office européen des brevets

(19)

(11) Publication number: **0 057 025**
**B1**

(12) **EUROPEAN PATENT SPECIFICATION**

(45) Date of publication of patent specification: **11.09.85**

(21) Application number: **82200026.1**

(22) Date of filing: **12.01.82**

(51) Int. Cl.⁴: **H 03 K 17/04,** H 03 K 19/017, G 11 C 8/00, G 11 C 7/06

(54) **Switching circuit.**

(30) Priority: **22.01.81 US 227335**

(43) Date of publication of application:
**04.08.82 Bulletin 82/31**

(45) Publication of the grant of the patent:
**11.09.85 Bulletin 85/37**

(84) Designated Contracting States:
**DE FR GB IT**

(56) References cited:
**US-A-3 995 171**
**US-A-4 048 518**
**US-A-4 087 704**
**US-A-4 145 622**

**ELECTRONICS INTERNATIONAL Vol. 53, No. 20, September 1980, New York R. SUD et al. "16-K Static RAM Takes New Route to High Speed" pages 117 to 123**

(73) Proprietor: **North American Philips Corporation 100 East 42nd Street 9th Floor New York, N.Y. 10017 (US)**

(72) Inventor: **Puar, Deepraj Singh c/o Int. Octrooibureau B.V. Prof.Holstlaan 6 NL-5656 AA Eindhoven (NL)**

(74) Representative: **Beckers, Hubertus Franciscus Maria et al INTERNATIONAAL OCTROOIBUREAU B.V. Prof. Holstlaan 6 NL-5656 AA Eindhoven (NL)**

## Description

The input node of semiconductor logic circuits, particularly circuits which provide large numbers of separate input signal connections, is usually characterized by a high parasitic capacitance. This capacitance must, necessarily, be charged or discharged to effect switching of the circuit. If the power dissipation of the means used to charge or discharge the node is held constant, the operating speed of the circuit is directly proportional to the node capacitance. Input node capacitance thus limits the speed/power product of prior art switching circuits.

"KOO (US—A—4,048,518) disclosed several circuits in which a decoupling transistor is used to isolate the input capacitance from the output terminal. These circuits, however, need a reference voltage source or an oscillator signal for their operation. A substantial improvement in speed/power product can be achieved by a new approach in generating the control voltage for the decoupling transistor".

It is, therefore, an object of this invention to increase the speed/power product of switching circuits by isolating a capacitance during switching.

In accordance with the invention the input node capacitance of a switching circuit is connected to its pull-up means through the channel of a depletion device. An output signal is derived from the voltage at a second node formed by the connection of the channel and the pull-up means. The gate of the depletion device is driven by the inverse of the signal at the second node. Positive feedback is thus provided to turn off the depletion device and isolate the parasitic capacitance during switching. The speed/power product of the circuit is thereby increased.

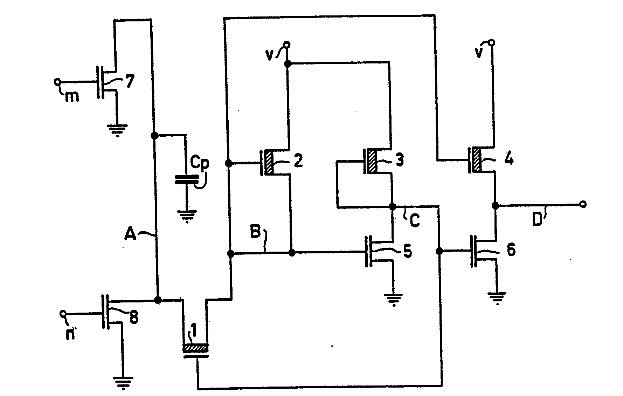

The present invention will now be described by way of example with reference to the single figure of the accompanying drawing, which figure is a schematic circuit diagram of a decoder/driver circuit which incorporates an electric circuit made in accordance with the invention.

Referring to the illustrated decoder/driver circuit, a pair of logical input signal $m$ and $n$ are applied, respectively, to the gates of enhancement transistors 7 and 8. The source terminals of transistors 7 and 8 are connected to an input node A which is characterized by a large parasitic capacitance $C_p$ to ground. The drain terminals of transistors 7 and 8 are connected directly to ground. Transistors 7 and 8 thus function to pull-down input node A toward ground potential whenever a HIGH logic level is applied to input $m$ or input $n$.

The gate and drain connections of depletion transistors 2 and 3 are respectively interconnected so that each of the devices functions as a current source. The source terminals of depletion transistors 2 and 3 are connected to a voltage supply V. The gate and drain of transistor 2 is connected to one end of the channel of a depletion transistor 1 at node B. The opposite end of the channel of depletion transistor 1 is connected to input node A. Transistor 2 thus functions to pull-up node A toward potential V whenever there is conduction through the channel of depletion transistor 1.

Node B is connected to the gate of an enhancement transistor 5. The drain of transistor 5 is connected to ground. The source of transistor 5 is connected through depletion transistor 3, which is connected as a current source, to the potential source V. The connection between the source of transistor 5 and the drain of transistor 3 is designated node C. Transistor 5 thus functions to invert the signal on node B at node C. The inverted signal at node C is fedback to the gate of depletion transistor 1.

A depletion transistor 4 and an enhancement transistor 6 are connected in series between the potential V and ground. The signal from node B is applied to the gate of transistor 4 and the signal from node C is applied to the gate of transistor 6. The connection between the drain of transistor 4 and the source of transistor 6 is designated node D. Transistors 4 and 6 thus function as a high power driver having an output at node D which corresponds to the signal at node B.

When input $m$ or $n$ is HIGH, node A is kept LOW by conduction through transistor 7 or 8. Node C is HIGH; the resistance of depletion device 1 is therefore in its lowest state and the potential at node B is close to the potential at node A. When input $m$ and input $n$ go LOW, node A starts to charge and its potential rises towards the supply potential V. A voltage drop across the channel of transistor 1 makes node B slightly closer to potential V than node A. This potential rise is relatively slow since the large parasitic capacitance $C_p$ (as well as the smaller capacitance at node B) must be charged through the resistance of transistor 2. As node B reaches the switching point of transistor 5, node C starts to drop in potential. This causes the channel resistance of device 1 to increase and results in node B rising toward potential V at a faster rate than node A. This positive feedback causes node C to fall at a faster rate and the resistance of device 1 to increase at a faster rate until the difference between the potential on node C and the potential on node A is less than or equal to the depletion threshold of device 1. At that point the channel resistance of device 1 is infinite. Node A is then clamped at a potential lower than the supply potential V; therefore when inputs $m$ or $n$ again go HIGH node A will discharge more quickly than if it had been charged to the full supply potential.

Node A is effectively isolated from node B and the rise time at node B is determined by the current flowing through transistor 2 to charge the small parasitic capacitance on node B. The rise time at node D will directly track the rise time at node B.

Node C is close to ground potential at this time. When input $m$ or input $n$ goes HIGH, transistor 7 or 8 starts to conduct. Node A discharges toward ground potential without hinderance from current through transistor 2 until the potential on node A is a depletion threshold below the potential on node C. At that point node B starts to drop in potential causing node C to rise in potential. This decreases the resistance of the channel of transistor 1 and creates positive feedback which causes node B to fall toward node A faster and further increases the potential on node C. Nodes A and B finally reach a potential close to ground and node C reaches full supply potential to produce the lowest possible resistance in the channel of device 1.

The present invention allows isolation of parasitic capacitance at a node without requiring external clock signals to effect switching. The circuit is thus ideally suited for use in static memory applications.

## Claims

1. An electronic circuit for switching the potential at a high capacitance node from a first potential state to a second logical inverse, potential state, comprising
pull-down means for switchably connecting the high capacitance node to a first potential;
pull-up means for connecting a second node to a second potential, the second node having a smaller capacitance than the high capacitance node;
a transistor device having a channel which functionally connects the high capacitance node to the second node and a gate electrode which controls conduction through the channel;
characterized by asynchronous means for inverting the potential state at the second node and for applying said inverted potential to the gate electrode of the transistor device, which is of the depletion type.

2. A circuit of claim 1, characterized in that the input node has a high parasitic capacitance.
3. The circuit of claim 1, characterized in that the pull-down means are enhancement mode transistors.
4. The circuit of claim 1, characterized in that the pull-up means is a depletion mode transistor.
5. The circuit of claim 1, characterized in that the means for inverting is an enhancement mode transistor having a drain connected to ground, a source connected to the supply potential through a resistance; and a gate connected to the second node.
6. An electronic circuit as claimed in claim 1, wherin the pull-down means comprise at least two input enhancement transistors, each having a drain connected to a first potential terminal, a gate connected for receipt of an input logical signal, and a source;
a first end of the channel of the transmitter device being connected to the sources of the input transistors;
first pull-up means connected between a second end of the channel of the transistor device and a second potential terminal; characterized by:
asynchronous means which comprises an inverting enhancement transistor having a drain connected to the first potential terminal, a gate connected to the second end of the channel of the transistor device, and a source connected to the gate of the transistor device, which is of the depletion type, the asynchronous means further comprising second pull-up means connected between the source of the inverting transistor and the second potential terminal; the electronic circuit further comprising
a driver enhancement transistor having a drain connected to the first potential terminal, a source connected for transmission of an output signal, and a gate connected to the source of the inverting transistor; and
a drive depletion transistor having a drain connected to the source of the driver enhancement transistor; a source connected to the second potential terminal, and a gate connected to the second end of the channel of the transistor device.
7. The circuit of claim 6, characterized in that the first and second pull-up means comprise depletion transistor current sources.

## Revendications

1. Circuit électronique pour la commutation du potentiel à une noeud de capacité élevée à partir d'un premier état de potentiel à une deuxième potentiel inverse logique, comprenant
des moyens de décharge pour connecter par commutation le noeud de capacité élevée à un premier potentiel;
des moyens de charge pour connecter un deuxième noeud à un deuxième potentiel, le deuxième noeud présentant une capacité plus faible que le noeud de capacité élevée;
un dispositif de transistor présentant un canal qui connecte fonctionellement le noeud de capacité élevée au deuxième noeud et une électrode porte, qui commande la conduction à travers le canal;
caractérisé par des moyens asynchrones pour inverser l'état de potentiel au deuxième noeud et pour appliquer ledit potentiel inversé à l'électrode porte du dispositif transistor, qui est de genre à appauvrissement.
2. Circuit selon la revendication 1, caractérisé en ce que le noeud d'entrée présente une capacité parasite élevée.

3. Circuit selon la revendication 1, caractérisé en ce que les moyens de décharge sont d'un transistor de mode d'enrichissement.

4. Circuit selon la revendication 1, caractérisé en ce que le moyen de charge est un transistor de mode d'appauvrissement.
5. Circuit selon la revendication 1, caractérisé en ce que le moyen d'inversion est un transistor de mode d'enrichissement présentant une évacuation mise à la terre, une source connectée au potentiel d'alimentation par une résistance et une porte connectée au deuxième noeud.

6. Circuit électronique selon la revendication 1, dans lequel le moyen de décharge comporte au moins deux transistors d'enrichissement d'entrée, présentant chacun une évacuation connectée à la première borne de potentiel, une porte connectée pour recevoir un signal logique d'entrée et une source;

une première extrémité du canal du dispositif de transistor étant connectée aux sources des transistors d'entrée;

des premiers moyens de charge connectées entre une deuxième extrémité du canal du transistor et une deuxième borne de potentiel caractérisé par

des moyens asynchrones comportant un transistor d'enrichissement inverseur présentant une évacuation connectée à la première borne de potentiel, une porte connectée à la deuxième extrémité du canal du transistor et une source connectée à la porte du transistor, qui est du genre à appauvrissement, les moyens asynchrones comprenant en outre des deuxièmes moyens de charge connectées entre la source du transistor inverseur et la deuxième borne de potentiel, circuit électronique qui comporte en outre

un transistor d'enrichissement d'entraînement présentant une évacuation connectée à la première borne de potentiel, une source connectée de façon à émettre un signal de sortie et une porte connectée à la source du transistor inverseur et

un transistor d'appauvrissement d'entraînement présentant une évacuation connectée à la source du transistor d'enrichissement et d'entraînement, une source connectée à la deuxième borne de potentiel, et une porte connectée à la deuxième extrémité du canal du transistor.

7. Circuit selon la revendication 6, caractérisé en ce que les premier et deuxième moyens de charge comportent des sources de courant de transistor d'appauvrissement.

**Patentansprüche**

1. Schaltkreis zum Umschalten des Potentials an einem Hochkapazitätskotenpunkt von einem ersten Potentialzustand auf einen zweiten, logisch invertierten Potentialzustand, mit Erneidrugungsmitteln zum schaltbaren Verbinden des Hochkapazitätsknotenpunkts mit einem ersten Potential, mit Erhöhungsmitteln zum Anlegen eines zweiten Potentials an einen zweiten Knotenpunkt, der eine geringere Kapazität als der Hochkapazitätsknotenpunkt hat, mit einer Transistoreinrichtung mit einem Kanal, der betriebsmässig den Hochkapazitätsknotenpunkt mit dem zweiten Knotenpunkt und einer Gatterelektrode verbindet, die die Kanalleitfähigkeit steuert, dadurch gekennzeichnet, dass asynchrone Mittel zum Invertieren des Potentialzustandes am zweiten Knotenpunkt und zum Anlegen des invertierten Potentials an die Gatterelektrode der Transistoreinrichtung vorgesehen sind, die vom Verarmungstyp ist.

2. Schaltung nach Anspruch 1, dadurch gekennzeichnet, dass der Eingangsknotenpunkt eine hohe Streukapazität hat.

3. Schaltung nach Anspruch 1, dadurch gekennzeichnet, dass die Erniedrigungsmittel Anreicherungstransistoren sind.

4. Schaltkreis nach Anspruch 1, dadurch gekennzeichnet, dass das Erhöhungsmittel einen Verarmungstransistor ist.

5. Schaltung nach Anspruch 1, dadurch gekennzeichnet, dass das Mittel zum Invertieren ein Anreicherungstransistor ist, dessen Drain mit Masse verbunden ist, dessen Source mit dem Speisepotential über einen Widerstand und dessen Gatter mit dem zweiten Knotenpunkt verbunden sind.

6. Elektronischer Schaltkreis nach Anspruch 1, dadurch gekennzeichnet, dass die Erniedrigungsmittel zumindest zwei Eingangstransistoren vom Anreicherungstyp mit je einer Drain, die mit je einem ersten Potentialanschluss verbunden ist, mit je Gatter zum Empfang eines logischen Eingangssignals und mit je einer Source enthalten, wobei ein erstes Ende des Kanals der Transistorschaltung mit den Sourceelektroden der Eingangstransistoren verbunden ist, und erste Erhöhungsmittel zwischen einem zweiten Ende des Kanals der Transistorschaltung und einem zweiten Potentialanschluss angeschlossen ist, dadurch gekennzeichnet, dass asynchrone Mittel vorgesehen sind, die einen invertierenden Transistor vom Anreicherungstyp enthalten, dessen Drain mit dem ersten Potentialanschluss verbunden ist, dessen Gate mit dem zweiten Ende des Kanals der Transistoreinrichtung und dessen Source mit dem Gate der Transistorschaltung verbunden sind, die vom Verarmungstyp ist, wobei die asynchronen Mittel weiter zweite Erhöhungsmittel zwischen der Source des invertierenden Transistors und dem zweiten Potentialanschluss enthalten, und der elektronische Schaltkreis weiter einen Treibertransistor vom Anreicherungstype mit einem Drain in Verbindung mit dem ersten Potentialanschluss, einer Source zum Übertragen eines Ausgangssignals und einem mit der Source des invertierenden Transistors verbundenen Gate, und einen Treibertransistor vom Verarmungstyp enthält, dessen Drain mit der Source des Treibertransistors vom Anreicherungstyp verbunden ist, dessen Source mit dem zweiten Potentialanschluss verbunden ist und dessen Gate mit dem zweiten Ende des Kanals der Transistorschaltung verbinden ist.

7. Schaltung nach Anspruch 6, dadurch gekennzeichnet, dass die ersten und zweiten Erhöhungsmittel Transistorstromquellen vom Verarmungstyp enthalten.